# EUROPEAN PATENT SPECIFICATION

(11) **EP 1 233 276 B1**
(45) Date of publication and mention of the grant of the patent: **01.12.2004**
(21) Application number: 01301472.5
(22) Date of filing: 19.02.2001
(51) Int. Cl.: G01R 31/30, G01R 31/3185

(54) **Boundary scan delay chain for crosschip delay measurement**
Abtastverzögerungskette zur Verzögerungsmessung
Chaîne de balayage périphérique présentant un retard pour la mesure du délai de propagation d'un signal à travers un circuit

(43) Date of publication of application: 21.08.2002
(73) Proprietor: LUCENT TECHNOLOGIES INC., Murray Hill, New Jersey 07974-0636 (US)
(72) Inventor: Schmid, Josef, Neumarkt/OPF 92318 (DE)
(74) Representative: Buckley, Christopher Simon Thirsk

(56) References cited:
- EP-A- 0 822 497
- EP-A- 0 994 361
- US-A- 4 771 251

## Description

The invention relates to a method for achieving delay measurement functionality, to a boundary scan cell, an integrated circuit and an electrical device each having delay measurement functionality and to a method for performing delay measurement.

As known for a person skilled in the art, usually the design of complex ASICs (Application Specific Integrated Circuits), SOCs (System On Chip) and/or ICs (Integrated Circuits) in time with required quality levels is a major challenge. Based thereon it is often very important for ASICs/SOCs/ICs, in the following description generally referred-to as integrated circuit, to have an easy accessible delay measurement path for several reasons. The delay of a long path running across the whole integrated circuit (cross-chip) of an electrical device through lots of instances, such as inverters and/or multiplexer makes it possible to measure final process parameters of the integrated circuit within a best case and worst case production process window.

Usually, this information is very important for the production testing at the vendor side. But very often this information also is necessary at the circuit pack or PCB (printed circuit board) level, system test level and/or even in the field, for example in case of problems occurred in functionality, timing and/or debugging, the "quality level" reached by the integrated circuit should be determined. Additionally, even for the characterization of the delay modeling during different design phases, such as estimation, floor planning, trial and/or final layout a dedicated delay path may help in qualifying the delay models together with the topological information of the database.

Thus, especially for a quality ranking of an electrical device, a design flow and/or a vendor dealing with complex integrated circuits it is very important to know how accurate the timing modeling fits with the real devices to estimate the timing margin between simulation models and their corresponding real devices. As mentioned above, in case of device problems it is important to know the relative device performance within the best case to worst case process variations. The process quality level can be determined, if a delay measured on an integrated circuit sample can be compared with the delay calculated by a timing simulation or by STA (static timing analysis) with certain process quality assumptions.

At present, a method for determining a quality level of a complex integrated circuit is involving a simple delay strobing on the (production) tester, which only indicates a passing or failing result but does not give an exact delay value. A further approach comprises the definition of a more or less random delay path within the design resulting in an ad hoc and none-standard solution concerning the topology, implementation, access and initialization.

Further known solutions for delay measurement and process characterization involve the use of a so called NAND-tree and/or a PROCMON-cell, i.e. a process-monitor-cell, both requiring additional instances, needing some efforts for implementation, initialization and/or access and might be vendor dependent as disclosed for example by LSI Logic, "Design Manual and Procmon Application Note" or Texas Instruments, "GS30 Design Manual and TDL Documentation".

The reader is referred to European patent applications EP-A-0822497 and EP-A-0994361 as background to the present invention.

The present invention provides a method of performing delay measurements of an integrated circuit produced by a production process, the integrated circuit having a scan chain for boundary scan testability, where the method comprises the steps of:
- entering a delay measurement mode;
- applying a test data signal to a test data input for boundary scan testability;
- performing the delay measurement at a separate delay chain output port which is the output of a local combinational path and which is additional to the test data output port to determine the performance of the integrated circuit; and the combinational local path does not interfere with the operation of the scan chain due to the delay chain output being kept in a tristate condition or by pulling the data input pin to operating voltage.

Preferred embodiments of the invention advantageously provide a new and improved approach for delay measurement of an integrated circuit that is substantially independent of vendors, technology and/or used development tools with a minimum of implementation effort in design time and gate resources.

Preferred embodiments provide a delay measurement functionality which can be produced at low costs and may cover a long path across an integrated circuit and with an easy access and initialization for performing the delay measurement without the need of a complicated and/or expensive IC-tester.

The inventive solution is achieved by the method of claim 1. Advantageous and/or preferred refinements and/or developments are the subject matter of the respective dependent claims.

It is proposed to provide at least one boundary scan cell, each having a storage layer between a scan input port and a scan output port constructed to be used within a scan chain of an integrated circuit for boundary scan testability, to analyze each of the boundary scan cells to identify a redundant state which is used to extend the scan cell by creating an additional local path between the respective scan input and scan output ports bypassing the respective storage layer and to implement each scan cell in the integrated circuit by creating said scan chain.

One of the advantages of the present invention is, that by means of said local bypass path the scan input port and the scan output port are connected in a purely combinational manner for performing a delay chain that may include all input, output and bi-directional boundary scan cells.

Moreover due to the fact that a redundant state is used for providing delay measurement functionality the inventive approach is still conform with the original boundary scan testability requirements.

By using a boundary scan cell for delay measurement having a functional layer and a storage layer which is bypassed for delay measurement no additional ports and/or test signals are necessary for the boundary scan cells used within the inventive boundary scan cell delay chain. Since furthermore no additional design instances and connectivity are necessary because only commercial or user library elements are modified internally and the cell ports are still the same, the implementation effort in design time and gate resources is minimal and substantially independent of vendors, technology and used development tools.

To obtain a relatively long delay chain for measuring to reduce the influence of fixed measuring errors and to preferably spread the delay chain across the whole chip to cover several process variances of the device, it is suggested to use so called boundary scan cells substantially avoiding any additional topological impact because only the boundary scan cells have to be placed and routed according the boundary scan and functional requirements. Since it is in general mandatory to use such boundary scan cells for a boundary scan chain in complex ASICs, SOCs and/or ICs, the delay chain, as an advantageously consequence, is implemented automatically.

According to a very preferred embodiment it is proposed to use boundary scan cells according to the IEEE Standard 1149.1, i.e. a standard methodology for interconnect testing on PCB, or to a standard derived from the IEEE Standard 1149.1.

Furthermore, according to a further preferred embodiment, it is proposed to connect the local bypass path and the storage layer of a respective scan cell with the scan output port via a multiplexer which is controlled by the shift signal from a given test access port controller to add a delay between the shift registers for increasing the hold time margin, i.e. to provide a skew safety margin for the test clock (TCK).

The local bypass path may comprise additional library elements for further delay or level adjusting, such as inversions.

Moreover, since in substantial no additional test ports and/or signals are necessary, an easier initialization and simulation setup as well as a delay measurement without a usual complex ASIC/IC tester even on board is guaranteed. Based thereon the preferred method of performing delay measurement of an integrated circuit or electrical device having an integrated circuit with an inventive delay chain merely comprises the entering of the delay measurement mode preferably by setting the boundary scan TAP-controller in a test-logic-reset-state (TRSTN =0) and by applying a data transition on the test data input (TDI). The delay measurement itself can be performed at the given test data output path (BSR_TDO) for the scan testability.

Depending on specific device architectures, an additional delay chain output port (DCO) connected with the test data output path (BSR_TDO) may be provided.

Even if boundary scan cells usually consist of different logic cells for different vendors and/or technologies there are no special logic cells required. Thus by modifying such scan cells according to the inventive approach a delay chain is ensured, which is in contrast to prior vendor specific delay chains substantially vendor and technology independent and is moreover still including boundary scan test compatibility. Since the inventive delay chain can be accessed by setting two test pins or ports to a certain value, wherein such test pins are pre-given, easily accessible on PCB due to IEEE 1149.1 requirements and/or can be shared with other test pins, no additional pins are required.

Thus, the inventive approach results in a new and improved standard methodology addressing the issues of delay measurement and "quality level" determination for integrated circuits, in general.

Subsequently the invention is described in more detail, in particular on the bases of a very preferred embodiment and with reference to the attached drawings, in which:
- Fig. 1: is a schematic diagram of a preferred boundary scan cell modified according to the invention,
- Fig. 2: is a schematic diagram of a standardized boundary scan cell prior to the modification according to Fig.1,
- Fig. 3: schematically depicts a chip having a boundary scan delay chain formed by serially connected scan cells according to Fig. 1, and
- Fig. 4: is schematically depicting an inventively modified boundary scan delay chain architecture based on boundary scan cells according to the IEEE Standard 1149.1.

For the following description and for the attached set of claims complex ASICs, SOCs and ICs are generally referred-to as integrated circuit. As known by a person skilled in the art, ordinary scan cells connected to form shift registers are often incorporated or implemented in integrated circuits for scan testability reasons.

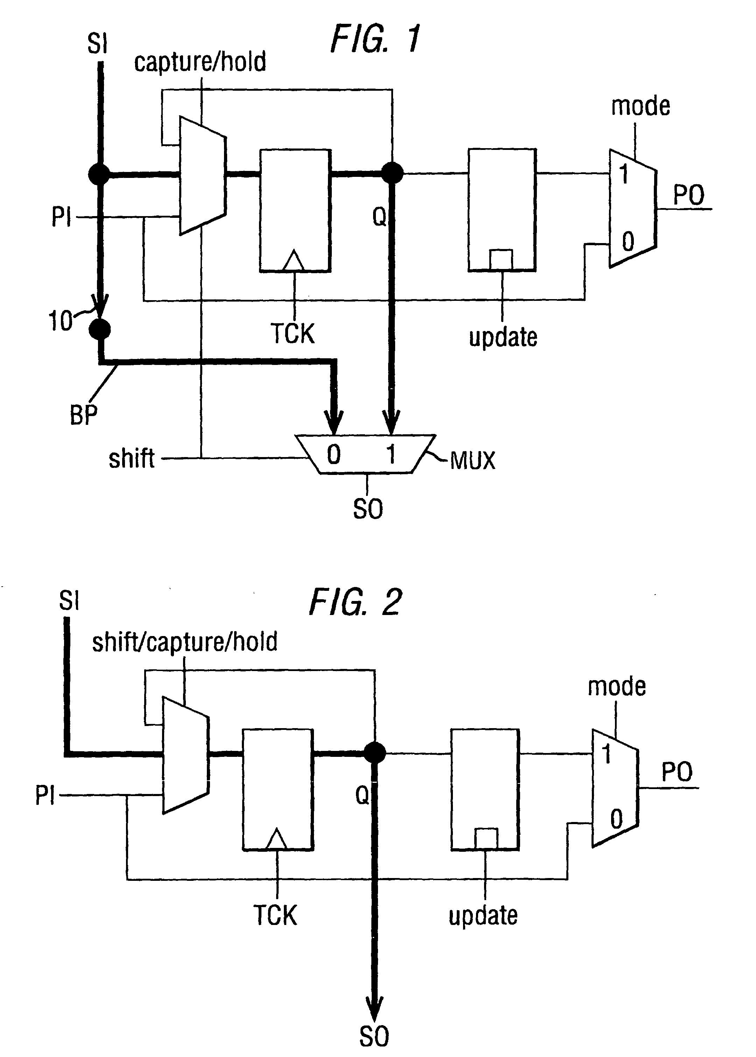

Based thereon, reference is made to Fig. 1 and 2 schematically showing a boundary scan cell having delay measurement functionality according to the invention and the standardized boundary scan cell according to the prior art without that functionality, respectively. However, for a better understanding of the preferred exemplary refinement of the invention based on a boundary scan cell (Fig. 2) according to IEEE Standard 1149.1 reference is made to IEEE Standard 1149.1 - 1990, "Test Access Port and Boundary-Scan Architecture".

As can be seen from Fig. 1 and 2 the boundary scan cell is connected between functional paths, such as between input buffers to core or between core to output buffers by a parallel input port PI and a parallel output port PO. In normal mode, i.e. in functional mode, the input port PI is directly connected to the output port PO by setting the mode signal to "0".

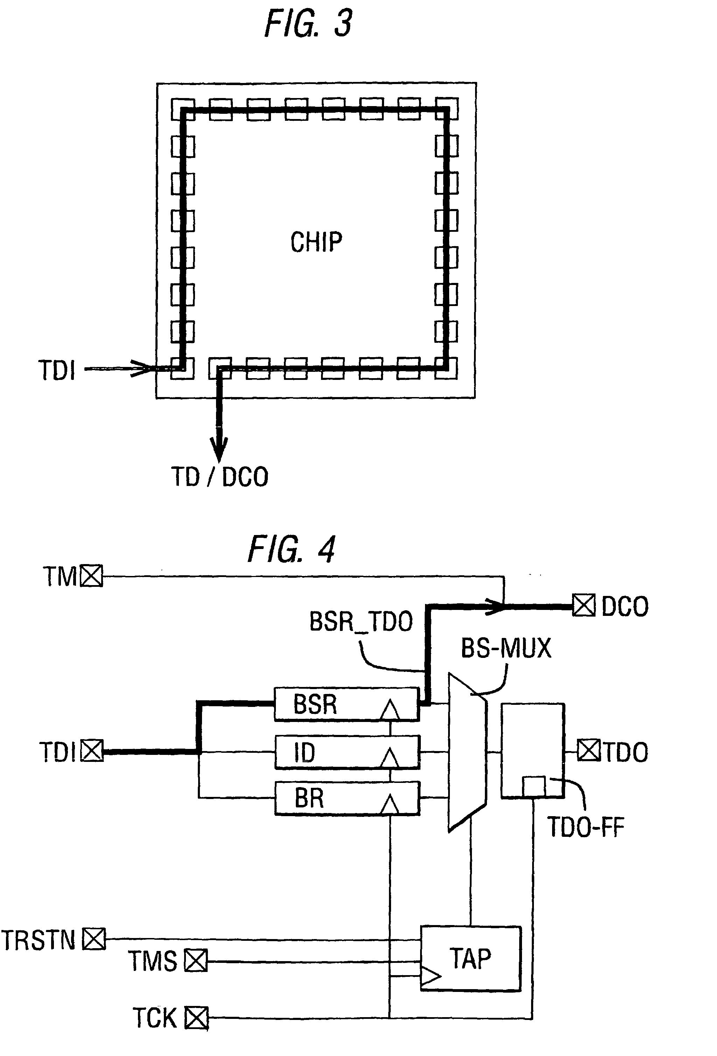

Between a scan input port SI and an scan output port SO a storage layer is integrated to form shift registers by serially connecting the scan output port SO with the scan input port SI of a further scan cell to generate a scan chain as it is exemplary depicted in Fig. 3 showing a chip having such a boundary scan chain. The control signals for shift, capture and hold functionality as well as the mode signal are generated by a test access port (TAP) controller, based on the preferred embodiment according to the IEEE Standard 1149.1.

Referring to the prior art according to Fig. 2, the information at the scan output port SO is of interest only in the shift mode and hence, the output SO is equal to Q. However, as can be seen from Fig. 2 showing the known ordinary boundary scan cell, in all other cases, i.e. if shift is set to "0" to be inactive, the output port SO is totally redundant.

According to the inventive approach as depicted in Fig. 1 this redundant status of the ordinary boundary scan cell is used to create an additional combinational delay path between the input port SI and the output port SO.

For realizing such additional combinational delay path the storage layer between the input and output ports SI and SO is bypassed by the inventive local path BP.

According to the preferred but exemplar embodiment of Fig. 1, the additional local bypass BP and the storage layer are connected via an additional multiplexer MUX which is also controlled by the shift signal from the TAP-controller. Consequently and based on that improvement, a delay mode can be entered by setting the shift mode as being inactive, i.e. shift is set to "0". During this delay mode the scan output port SO is not redundant but in functional dependence on the input port SI, i.e. SO = f(SI).

Moreover, by setting the shift mode to be active to obtain at the scan output port SO the information Q, i.e. if shift mode = "1", then SO = Q and the original scan mode functionality additionally may be used.

As mentioned above, by connecting a plurality of scan cells serially to form a shift register, a scan chain according to Fig. 3 is created. Thus, by using an amount of the inventive modified scan cells (Fig. 1) to form such a scan chain with the input port SI of the first scan cell connected to a test data input TDI preferably providing the stimuli input for boundary scan testability and the output port SO of the scan cell forming the end of the scan chain to a test data output TDO an additional delay chain is automatically created from the test data input TDI to the end of the boundary scan register BSR, such as to BSR_TDO (Fig. 4). Based on the exemplar refinement using a boundary scan cell according to the IEEE Standard 1149.1 a delay chain is performed at least from TDI to BSR_TDO, as can be seen from Fig. 4 depicting the specific boundary scan delay chain architecture according to the preferred embodiment.

Thus, by use of existing, usually standardized boundary scan cells and by creating a purely combinational delay path all input, output and/or bi-directional boundary scan cells may be included in the delay chain, wherein no additional ports or test signals are necessary for the modified delay chain cells. Furthermore, since merely scan library elements are modified internally and the cells have to be routed and placed according to the scan and functional requirements no additional design instances, connectivity and/or topological impact are necessary for creating that inventive scan delay chain in a standardized manner.

Moreover, by using boundary scan cells, a delay chain running across a whole integrated circuit, such as on a chip according to Fig. 3, can be achieved to cover several process variances of the device comprising that integrated circuit or chip for performing a so-called cross-chip delay measurement incorporating a plurality of nodes, elements, layers and/or vias.

Based thereon, a delay between the test data input TDI passing the boundary scan register BSR to the BSR_TDO-path, according to the highlighted delay measurement path of Fig. 4, is in functional dependence on the number of pins, i.e. substantially of the number of boundary scan cells incorporated, on the multiplexers, inverters and/or other delay or library elements embedded in the improved scan cells, on cross-chip interconnections, buffers, capacitive loads, on the process, the temperature and/or on the power supply variations.

As can be seen in Fig. 1, the inventive local bypass path BP can further comprise library elements 10 for additionally connecting respective delay elements. In any case, however, no additional design instances and connectivity are necessary, since only given scan library elements are modified internally and the cell ports are still the same within the modified delay scan cell. Furthermore, since the improved scan cells merely have to be routed and placed according to the usually standardized scan and functional requirements, a delay chain including the improved boundary scan cells is still conform to the boundary scan functionality requirements, i.e. with regard to the exemplary embodiment to the IEEE Standard 1149.1.

Moreover, the additional multiplexer MUX within the local bypass path BP is advantageously adding a delay between the shift registers which increases the hold time margin, i.e. to improve the skew safety margin for the test clock TCK for avoiding skew and/or holding-time problems.

Mainly referring next to Fig. 4, the principle delay chain access and initialization mechanism based on the preferred embodiment, i.e. based on the IEEE Standard 1149.1, is described in more detail. To get into the boundary scan delay chain mode it is necessary to find a state within the test access port controller (TAP) where the shift control is not active. This, however, is the case in the test-logic-reset state which is (asynchronously) entered when the reset pin TRSTN is set to "0". As a consequence, the path from the boundary scan register BSR comprising the serially connected boundary scan cells to the test data output pin TDO, i.e. in particular to the path BSR_TDO, is in functional dependence on the test data input TDI for providing the test stimuli input.

However, based on the example using a boundary scan cell chain according to the IEEE Standard 1149.1 the delay path or chain is still not accessible from the device pin. According to that standard an other part or register, such as a bypass register BR, may be automatically selected and not the boundary scan register BSR. Furthermore, also a multiplexer BS-MUX and a test data output flip-flop TDO-FF acts as blocking elements for the inventive boundary scan delay chain. Thus, according to a preferred refinement to still keep the access and initialization simple, the BSR_TDO-path is bypassing the multiplexer BS-MUX and the output flip-flop TDO-FF to a separate delay chain output test pin DCO.

It has to be noted, however, that there are no compelling reasons in general, to provide a delay test pin DCO separated from a given test data output pin TDO, as it is obvious for a person skilled in the art.

The separate test pin DCO can be controlled by a separate test mode signal TM to keep it in tristate condition during functional mode. But even this is optional, since the test data input pin TDI is pulled to operating voltage V_{DD} according to the standard, i.e. TDI = "1" and hence, keeps the whole boundary scan delay chain path quiescent in functional mode. As mentioned above with regard to the test pin DCO also the pin TM may be shared with other test pins, such as a test pin for a RAM (random access memory) test. mode, a PLL (phase locked loop) test mode, a core scan test mode and/or similar test modes.

Consequently, for performing a delay measurement, in particular a cross-chip delay measurement an easy and direct access by a given test data input TDI and test data output TDO or delay chain output DCO is provided when using inventively modified boundary scan cells. Also, the quality level of a device can easily be determined on a circuit pack without any need of additional IC-testers or special loadboards.

For an implementation of the inventive scan delay chain the following flow preferably may be used. Prior to create a respective (boundary) scan-chain according to given scan and functionality requirements by means of specific favorite tools, the standard boundary scan cells have to be extended into the inventive boundary scan delay chain-cells according to the afore-discussed inventive approach. During the logic synthesis of the scan-chain, the boundary scan delay chain path is defined as being a false path to avoid futile optimization efforts. Subsequent to the performing of simulation to verify a correct standardized scan behavior, a static timing analysis (STA) as known should be performed on the respective delay chain output-port DCO for an estimated, floorplan and/or layout timing. Based on that timing information an estimation of the accuracy of wiring and/or load models and the definition of a process window, i.e. the best and worst case production process window can be carried out.

According to the practical use of the inventive scan delay chain measurement providing a substantially standardized. methodology, there are basically three different fields of applications, i.e. during the design, the production of an electrical device comprising complex integrated circuits and in the field itself.

In detail, one of the preferred applications is the delay characterization during the design implementation process with link to layout. Starting from a top-level assembly, an estimated (wiring) delay calculation and static timing analysis is performed. The implementation is improved by floor planning and trial layout generation which incorporates more or less accurate topological information, which is back-annotated into the standard delay format database. It finally concludes with the frozen layout. During this whole process the timing behavior concerning best case and worst case (BC/WC) variations, load, wiring and/or routing estimations and/or variations can be characterized with the inventive delay chain preferably based on the dedicated boundary scan cells which elements are stable during the whole flow.

According to a second field of application, the delay measurement of fabricated devices may be performed. This can be done with a special but simple test-program on the production tester having a measurement feature.

Furthermore, the delay measurement can easily be done with the device mounted on board during a system-test and even in the field with the simple access and initialization possibilities as described above with regard to the IEEE Standard 1149.1.

In all cases of preferred applications, the device quality, i.e. the location of the propagation delay within the BC/WC (best/worst case) delay window can easily be determined.

Although the invention is described with regard to a preferred embodiment based on or derived from the IEEE Standard 1149.1, it should be obvious for a person skilled in the art that several modifications depending on specific requirements can be carried out.

## Claims

1. A method of performing delay measurements of an integrated circuit produced by a production process, the integrated circuit having a scan chain for boundary scan testability, where the method comprises the steps of:
- entering a delay measurement mode;
- applying a test data signal to a test data input (TD1) for boundary scan testability;
- performing the delay measurement at a separate delay chain output port (DCO), which is the output of a local combinational path and which is additional to the test data output port (TDO) for boundary scan testability, to determine the performance of the integrated circuit; and the combinational local path does not interfere with the operation of the scan chain due to the delay chain output (DCO) being kept in a tristate condition or by pulling the data input pin (TDI) to operating voltage (V_{DD}).

2. A method of claim 1, comprising the step of performing the delay measurement at the test data output port (TDO) for boundary scan testability.

3. A method of claim 1 or 2 in which the scan cells forming the scan chain have a storage layer between a scan input port (SI) and an output port (SO), an additional combinational path (BP) between the scan input port (SI) and the scan output port (SO) of a respective scan cell, and a multiplexer (MUX), connected to the output of the additional combinational path (BP) and the output of the storage layer, to provide the scan output port (SO) signal; and
the steps of applying a test data signal to a test data input (TDI) also consists in connecting the scan input port (SI) of a first scan cell to a test data input port (TDI) for boundary scan testability and the scan output port (SO) of a scan cell forming the end of the scan chain via a circuitry (BSR_TDO, BS-MUX, TDO-FF) to a test data output port (TDO) for boundary scan testability; and connecting the output port (SO) of a boundary scan cell forming the end of the scan chain to the separate delay chain output port (DCO) via a test data output path (BSR_TDO).

4. A method of claim 3 wherein the step of applying a test data signal also comprises the providing of the at least one boundary scan cell according to the IEEE Standard 1149.1.

5. Method of claim 3 or 4, wherein the step of performing the delay measurement comprises the step of implementing a local path (BP) between said respective two scan ports (SI, SO) by bypassing the respective storage layer of a boundary scan cell so as to provide the additional combinational path.

6. Method of claim 3,4 or 5, wherein the combinational path is connected to the scan output port (SO) via a multiplexer (MUX) controlled by the shift signal from a tes access port controller.

7. A method of any of claims 3 to 6, wherein the combinational path (BP) is defined as false path during synthesizing of the scan chain.

## Patentansprüche

1. Verfahren zur Durchführung von Verzögerungsmessungen einer durch einen Produktionsprozeß hergestellten integrierten Schaltung, wobei die integrierte Schaltung eine Scan-Kette für Boundary-Scan-Prüfbarkeit aufweist, mit den folgenden Schritten:
- Eintreten in einen Verzögerungsmeßmodus;
- Anlegen eines Testdatensignals an einen Testdateneingang (TDI) für Boundary-Scan-Prüfbarkeit;
- Durchführen der Verzögerungsmessung an einem separaten Verzögerungskettenausgangsport (DCO), der der Ausgang eines lokalen kombinatorischen Weges ist und der zusätzlich zu dem Testdatenausgang (TDO) für Boundary-Scan-Prüfbarkeit vorliegt, um die Leistungsfähigkeit der integrierten Schaltung zu bestimmen; und der kombinatorische Weg stört nicht den Betrieb der Scan-Kette, weil der Verzögerungskettenausgang (DCO) in einem Tristate-Zustand gehalten wird, oder indem der Dateneingangsanschluß (TDI) auf Betriebsspannung (V_{DD}) gezogen wird.

2. Verfahren nach Anspruch 1 mit dem Schritt des Durchführens der Verzögerungsmessung an dem Testdatenausgangsport (TDO) für Boundary-Scan-Prüfbarkeit.

3. Verfahren nach Anspruch 1 oder 2, bei dem die die Scan-Kette bildenden Scan-Zellen folgendes aufweisen: eine Speicherschicht zwischen einem Scan-Eingangsport (SI) und einem Ausgangsport (SO), einen zusätzlichen kombinatorischen Weg (BP) zwischen dem Scan-Eingangsport (SI) und dem Scan-Ausgangsport (SO) einer jeweiligen Scan-Zelle und einen Multiplexer (MUX), der mit dem Ausgang des zusätzlichen kombinatorischen Weges (BP) und dem Ausgang der Speicherschicht verbunden ist, um das Signal des 'Scan-Ausgangsports (SO) bereitzustellen; und
die Schritte des Anlegens eines Testdatensignals an einen Testdateneingang (TDI) auch darin bestehen, den Scan-Eingangsport (SI) einer ersten Scan-Zelle für Boundary-Scan-Prüfbarkeit mit einem Testdateneingangsport (TDI) und den Scan-Ausgangsport (SO) einer das Ende der Scan-Kette bildenden Scan-Zelle über eine Schaltung (BSR_TDO, BS-MUX, TDO-FF) für Boundary-Scan-Prüfbarkeit mit einem Testdatenausgangsport (TDO) zu verbinden; und den Ausgangsport (SO) einer das Ende der Scan-Kette bildenden Boundary-Scan-Zelle über einen Testdatenausgangsweg (BSR_TDO) mit dem separaten Verzögerungskettenausgangsport (DCO) zu verbinden.

4. Verfahren nach Anspruch 3, wobei der Schritt des Anlegens eines Testdatensignals außerdem das Bereitstellen der mindestens einen Boundary-Scan-Zelle gemäß dem IEEE-Standard 1149.1 umfaßt.

5. Verfahren nach Anspruch 3 oder 4, wobei der Schritt des Durchführens der Verzögerungsmessung den Schritt des Implementierens eines lokalen Weges (BP) zwischen den beiden jeweiligen Scan-Ports (SI, SO) durch Umgehen der jeweiligen Speicherschicht einer Boundary-Scan-Zelle, um so den zusätzlichen kombinatorischen Weg bereitzustellen, umfaßt.

6. Verfahren nach Anspruch 3, 4 oder 5, wobei der kombinatorische Weg über einen durch das Shift-Signal aus einer Testzugangsportsteuerung gesteuerten Multiplexer (MUX) mit dem Scan-Ausgangsport (SO) verbunden wird.

7. Verfahren nach einem der Ansprüche 3 bis 6, wobei der kombinatorische Weg (BP) während der Synthese der Scan-Kette als falscher Weg definiert ist.

## Revendications

1. Procédé de prise de mesures de retard produites par le processus de production d'un circuit intégré ayant une chaîne de scrutation de testabilité par scrutation en limite, où le procédé comprend les étapes de :
- passage sur un mode de mesure de retard ;
- application d'un signal de données de test à une entrée de données de test (TDI) de testabilité par scrutation en limite ;
- prise de la mesure de retard au niveau d'un port de sortie de chaîne de retard (DCO) séparé, lequel est la sortie d'un trajet combinatoire local et qui est en supplément du port de sortie de données de test (TDO) de testabilité par scrutation en limite, afin de déterminer la performance du circuit intégré ; et le trajet local combinatoire n'interfère pas avec l'opération de la chaîne de scrutation en raison du maintien de la sortie de chaîne de retard (DCO) sur une condition de triple état ou en tirant la broche d'entrée de données (TDI) à une tension opérationnelle (V_{DD}).

2. Procédé selon la revendication 1, comprenant l'étape de prise de la mesure de retard au niveau du port de sortie de données de test (TDO) de testabilité par scrutation en limite.

3. Procédé selon la revendication 1 ou 2, dans lequel les cellules de scrutation formant la chaîne de scrutation ont une couche de stockage entre un port d'entrée de scrutation (SI) et un port de sortie (SO), un trajet combinatoire supplémentaire (BP) entre le port d'entrée de scrutation (SI) et le port de sortie de scrutation (SO) d'une cellule de scrutation respective, et un multiplexeur (MUX), connecté à la sortie du trajet combinatoire supplémentaire (BP) et à la sortie de la couche de stockage, afin de fournir le signal du port de sortie de scrutation (SO) ; et
l'étape d'application d'un signal de données de test à une entrée de données de test (TDI) consiste également à connecter le port d'entrée de scrutation (SI) d'une première cellule de scrutation à un port d'entrée de données de test (TDI) de testabilité par scrutation en limite et le port de sortie de scrutation (SO) d'une cellule de scrutation formant la fin de la chaîne de scrutation par l'intermédiaire de circuits (BSR_TDO, BS-MUX, TDO-FF) à un port de sortie de données de test (TDO) de testabilité par scrutation en limite, et à connecter le port de sortie (SO) d'une cellule de scrutation en limite formant la fin de la chaîne de scrutation au port de sortie de chaîne de retard (DCO) séparé par l'intermédiaire d'un trajet de sortie de données de test (BSR_TDO).

4. Procédé selon la revendication 3, dans lequel l'étape d'application d'un signal de données de test comprend en outre la fourniture d'au moins la cellule de scrutation en limite selon la norme 1149.1 de l'IEEE.

5. Procédé selon la revendication 3 ou 4, dans lequel l'étape de prise de la mesure de retard comprend l'étape de mise en oeuvre d'un trajet local (BP) entre lesdits deux ports de scrutation (SI, SO) respectifs en contournant la couche de stockage respective d'une cellule de scrutation en limite de manière à fournir le trajet combinatoire supplémentaire.

6. Procédé selon la revendication 3, 4 ou 5, dans lequel le trajet combinatoire est connecté au port de sortie de scrutation (SO) par l'intermédiaire d'un multiplexeur (MUX) commandé par le signal de décalage provenant d'un contrôleur de port d'accès de test.

7. Procédé selon l'une quelconque des revendications 3 à 6, dans lequel le trajet combinatoire (BP) est défini comme un faux trajet durant la synthétisation de la chaîne de scrutation.
